# EUROPEAN PATENT APPLICATION

(11) **EP 2 372 789 A2**
(43) Date of publication of application: **05.10.2011**
(21) Application number: 10163105.9
(22) Date of filing: 18.05.2010
(51) Int. Cl.: H01L 31/18

(54) **Method of forming solar cell**

(30) Priority: 30.03.2010 TW 099109569
(71) Applicant: E-Ton Solar Tech Co., Ltd., Tainan T'ai nan 70955 (TW)
(72) Inventor: Huang, Po-Sheng, 710, Tainan County (TW); Lu, Wei-Chih, 106, Taipei City (TW); Ku, Chen-Hao, 428, Taichung County (TW)
(74) Representative: Becker Kurig Straus

(57) **Abstract**

A method of forming solar cell includes providing a substrate (30, 50, 70) having a first region (301, 501, 701) and a second region (302, 502, 702). A dopant source layer (32, 54, 74) is then formed on the substrate (30, 50, 70). A laser beam is used to locally irradiate the dopant source layer (32, 54, 74) corresponding to the first region (301, 501, 701) to locally diffuse the dopants of the dopant source layer (32, 54, 74) on the first region (301, 501, 701) downward into the substrate (30, 50, 70). The laser beam also changes the surface property of the substrate (30, 50, 70) in the first region (301, 501, 701) to form a visible patterned mark. The dopant source layer (32, 54, 74) is then removed, and a patterned electrode (40, 60, 80) is formed on the first region (301, 501, 701) of the substrate (30, 50, 70) using the visible patterned mark as an alignment mark.

## Description

The present invention relates to a method of forming the solar cell according to the pre-characterizing clause of claim 1.

The power generating efficiency of the solar cell mainly depends on the power conversion efficiency, and the power conversion efficiency mostly depends on the following three factors including: the light absorbability; the recombination between the electrons and the electron holes; and the contact resistance. Among these three factors, the light absorbability and the recombination between the electrons and the electron holes are limited by the properties of the materials; however, in terms of contact resistance, selective diffusion techniques can reduce the contact resistance between the metallic electrode and the semiconductor layer, thus raising the power conversion efficiency of the solar cell. The method of selective diffusion utilizes a selective emitter structure which heavily dopes the region between the metallic electrode and the semiconductor layer, but lightly dopes the rest regions of the semiconductor layer. Thus, the contact resistance can be reduced without raising the recombination rate between the electrons and the electron holes.

In the conventional techniques, several methods for forming a selective emitter have been presented. For example, in US patent 6,429,037, Wenham reveals a method of forming a selective emitter where an electroless plating process is used to manufacture the metal contact; however, the parameters affecting the electroless plating process are difficult to control and the electroless plating process of the metal contact is time consuming resulting in higher manufacturing costs, which is non-ideal for mass production.

In addition, in US publication 2009/0183768, Wenham reveals another method of forming a selective emitter where a metallic electrode is disposed perpendicularly with respect to the heavily doped regions. However under such practice, a great portion of the metallic electrode contacts the lightly doped regions making the contact resistance difficult to be reduced effectively and the power conversion efficiency cannot be further improved.

This in mind, the present invention aims at providing a method of forming a solar cell that improves the power conversion efficiency through optimal alignment of the electrode.

This is achieved by a method of forming a solar cell according to claim 1. The dependent claims pertain to corresponding further developments and improvements.

As will be seen more clearly from the detailed description following below, the claimed method of forming a solar cell includes a selective emitter that uses a laser beam to change the surface property of the substrate to form a visible patterned mark to be used as an alignment mark for the patterned electrode, reducing contact resistance between the patterned electrode and the heavily doped region.

In the following, the invention is further illustrated by way of example, taking reference to the accompanying drawings. Thereof
FIG. 1 to FIG.3 illustrates FIGs. 1-3 of US patent 6,429,037.
FIG. 4 to FIG. 7 are schematic diagrams illustrating a method of forming a solar cell in accordance with a first preferred embodiment of the present invention.
FIG. 8 to FIG. 11 are schematic diagrams illustrating a method of forming a solar cell in accordance with a second preferred embodiment of the present invention.
FIG. 12 to FIG. 15 are schematic diagrams illustrating a method of forming a solar cell in accordance with a third preferred embodiment of the present invention.

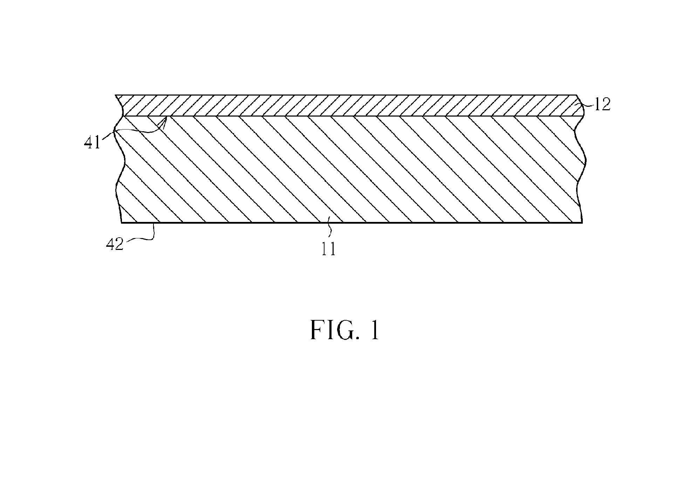

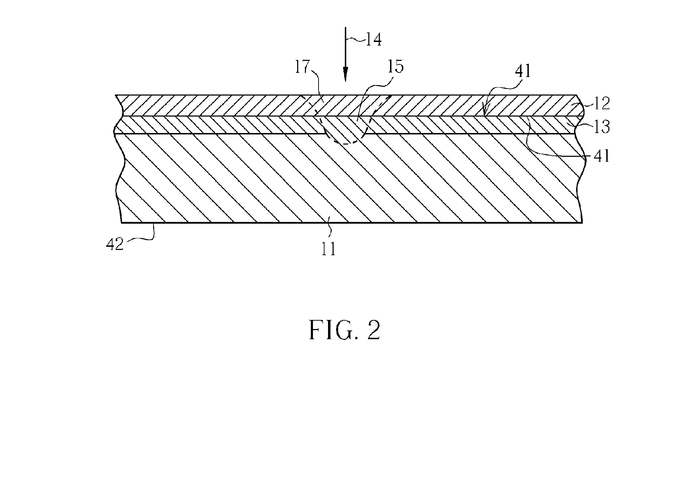

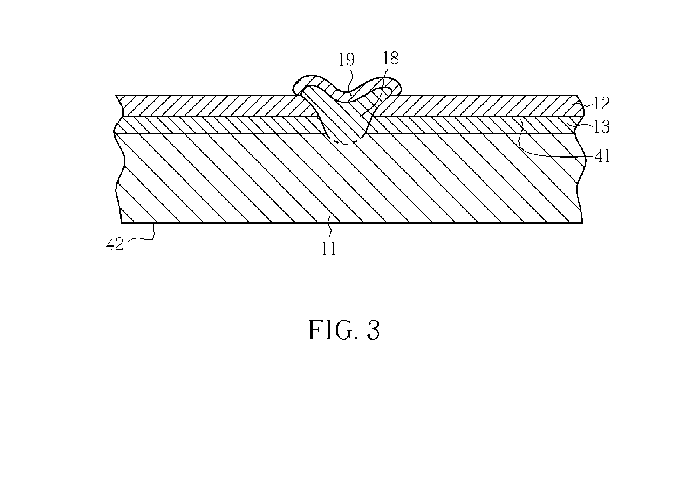

As disclosed in FIG. 1 of US patent 6,429,037, first a substrate 11 may be provided and a dielectric layer 12 containing dopants is formed on a front surface 41 of the substrate 11. In FIG. 2, a thermal diffusion process is performed so that the dopants in the dielectric layer 12 diffuse downward into the substrate 11, forming a lightly diffused emitter 13. Subsequently, a laser 14 is used to locally melt the dielectric layer 12 to expose a portion of the substrate 11, and to diffuse the dopants in the dielectric layer 12 downward so that the corresponding region of the substrate 11 is heavily doped. As illustrated in FIG. 3, then a metal contact 19 is formed on the exposed surface of the substrate 11 by electroplating techniques, which forms the selective emitter structure. An electroless plating process is used to manufacture the metal contact. However, the electroplating process of the metal contact results in higher manufacturing cost, which is non-ideal for mass production.

In US publication 2009/0183768, Wenham reveals another method of forming a selective emitter. A plurality of heavily doped regions is formed aligned in parallel with one another along a horizontal direction of the substrate. A metallic electrode is then formed perpendicularly aligned with the heavily doped regions so that the metallic electrode and the heavily doped regions are partially overlapping with one another, forming a selective emitter structure. The metallic electrode is disposed perpendicularly with respect to the heavily doped regions; however under such practice, a great portion of the metallic electrode does not contact the heavily doped regions but instead, a great portion of the metallic electrode contacts the lightly doped regions. When a great portion of the metallic electrode contacts the lightly doped regions, the contact resistance cannot be reduced effectively and the power conversion efficiency cannot be further improved.

To provide a better understanding of the present invention, preferred embodiments will be detailed as follows. The preferred embodiments of the present invention are illustrated in the accompanying drawings with numbered elements to elaborate the contents and effects to be achieved, but applications of the present invention are not limited.

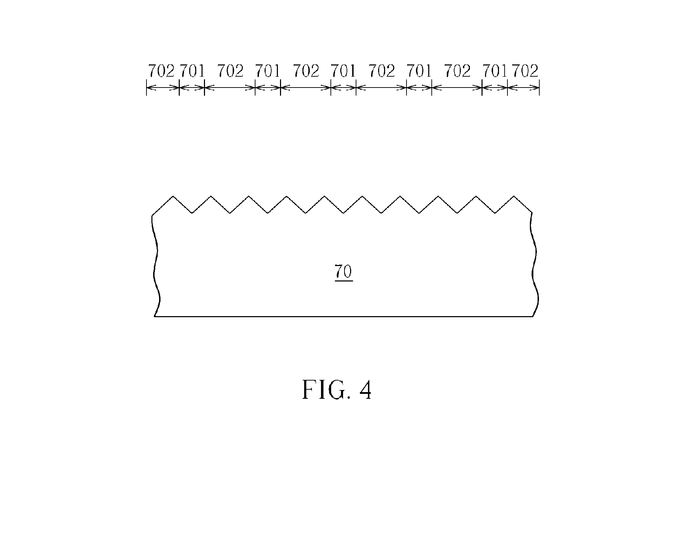

Referring to FIG. 4 to FIG. 7, FIG. 4 to FIG. 7 are schematic diagrams illustrating a method of forming a solar cell in accordance with a first preferred embodiment of the present invention. As illustrated in FIG. 4, first a substrate 70 is provided, and the substrate 70 includes a first region 701 and a second region 702. In accordance with the present embodiment, the substrate 70 is a silicon substrate, and the substrate 70 has a first doping type, e.g. a p-type doping. In addition, a texturing process may be optionally performed on the surface of the substrate 70 to reduce the reflection of incident light, which therefore increases the amount of incident light, and improves the power conversion efficiency.

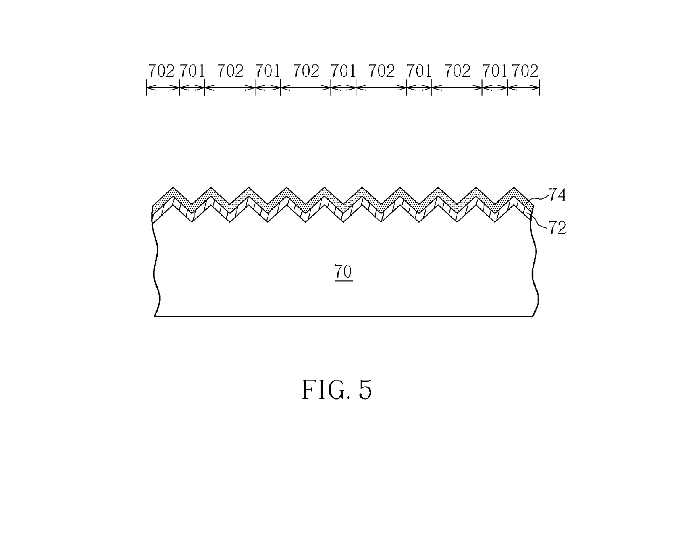

As illustrated in FIG. 5, then a lightly doped region 72 is formed in the first region 701 and the second region 702 of the substrate 70, and a dopant source layer 74 is formed in the first region 701 and the second region 702 of the substrate 70 simultaneously. The lightly doped region 72 has a second doping type, e.g. an n-type doping. The lightly doped region 72 forms a PN junction with the substrate 70. In accordance with the present embodiment, the manufacturing of the lightly doped region 72 and the dopant source layer 74 is achieved using a thermal diffusion process. For example, the substrate 70 may be loaded into a high temperature furnace, and a source gas containing one or multiple types of dopants is introduced into the high temperature furnace to form the lightly doped region 72.

In accordance with the present embodiment, since the lightly doped region 72 has the second doping type, i.e. n-type doping, phosphorus-containing gas such as phosphorus oxychloride (POCl3) gas may be used as the source gas, while the oxygen gas, nitrogen gas and other gases may also be introduced as well. The phosphorus oxychloride gas would react with the oxygen gas in advance to form phosphorus pentoxide (P2O5), the phosphorus pentoxide would further react with the silicon of the substrate 70 to generate phosphorus atoms, and the high temperature allows the phosphorus atoms to diffuse into the substrate 70 to form an n-type lightly doped region 72. It is to be noted that, after the thermal diffusion process, not only the first region 701 and the second region 702 near the surface of the substrate 70 have thoroughly become the n-type lightly doped region 72, but a dopant containing dopant source layer 74 is simultaneously formed on the surface of the substrate 70 in the first region 701 and the second region 702.

It is to be noted that, in accordance with the present embodiment, the dopant source layer 74 is a phosphosilicate glass (PSG) layer, but as the types of source gas varies, the dopant contained in the lightly doped region 72 and the dopant source layer 74 is not limited to a single type of dopant, and may be multiple types of dopants. In addition, the surface resistance of the lightly doped region 72 is substantially between 60 ohm/cm2 and 200 ohm/cm2, but is not limited thereto.

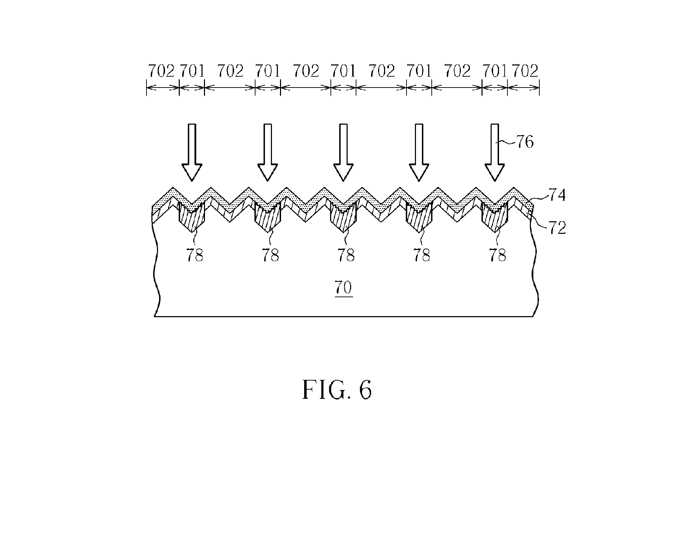

As illustrated in FIG. 6, next a laser doping process is performed using a laser beam 76 to locally irradiate the dopant source layer 74 corresponding to the first region 701 of the substrate 70, so that the dopants in the dopant source layer 74 on the first region 701 irradiated by the laser beam 76 absorb the energy of the laser beam 76 and diffuse downward into the substrate 70 to form a heavily doped region 78. The surface resistance of the heavily doped region 78 is substantially between 5 ohm/cm2 and 100 ohm/cm2, but is not limited thereto. In addition, the laser beam 76 irradiating the first region 701 would melt the surface of the substrate 70 in the first region 701 so that the surface of the substrate 70 is recrystallized and the surface roughness in the first region 701 of the substrate 70 is changed. Thus, the surface roughness of the substrate 70 in the first region 701 would be significantly different from the surface roughness of the substrate 70 in the second region 702, which forms a visible patterned mark. In accordance with the present embodiment, the laser beam 76 includes a pulsed laser beam, and the wavelength of the laser beam 76 is substantially between 200 nanometers and 2000 nanometers, but the types and wavelength of the laser beam 76 are not limited thereto.

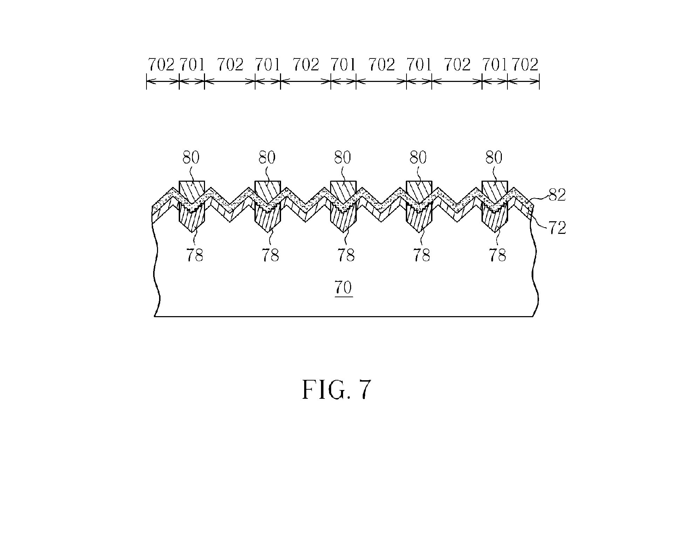

As illustrated in FIG. 7, then the dopant source layer 74 is removed from the surface of the substrate 70, and the visible patterned mark is used as an alignment mark for forming a patterned electrode 80 on the surface of the substrate 70 in the first region 701. With the alignment mark, the patterned electrode 80 may be precisely disposed on the first region 701 and in contact with the heavily doped region 78, which effectively reduces the contact resistance. Furthermore, before forming the patterned electrode 80, an anti-reflective layer may be formed on the surface of the substrate 70 to reduce the reflection of incident light which increases the light utilization efficiency. In accordance with the present embodiment, the patterned electrode 80 may be formed by a screen printing process or an ink-jet printing process, but is not limited thereto.

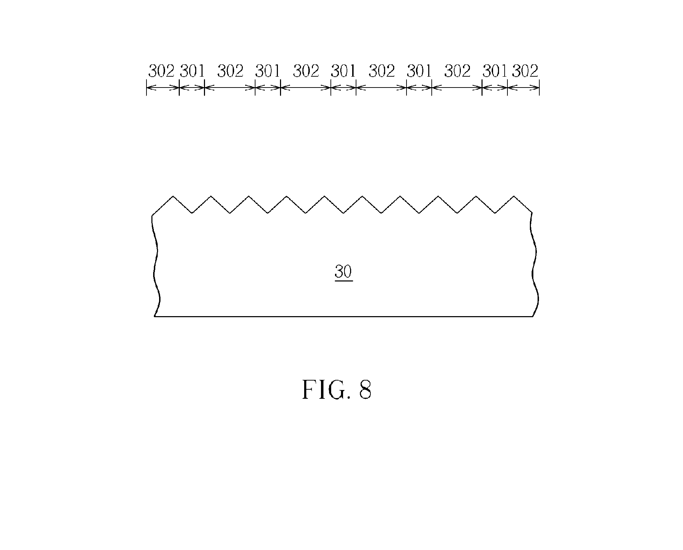

Referring to FIG. 8 to FIG. 11, FIG. 8 to FIG. 11 are schematic diagrams illustrating a method of forming a solar cell in accordance with a second preferred embodiment of the present invention. As illustrated in FIG. 8, first a substrate 30 is provided, and the substrate 30 includes a first region 301 and a second region 302. In accordance with the present embodiment, the substrate 30 is a silicon substrate, and the substrate 30 has a first doping type, e.g. a p-type doping. In addition, a texturing process may be optionally performed on the surface of the substrate 30 to form a rough surface.

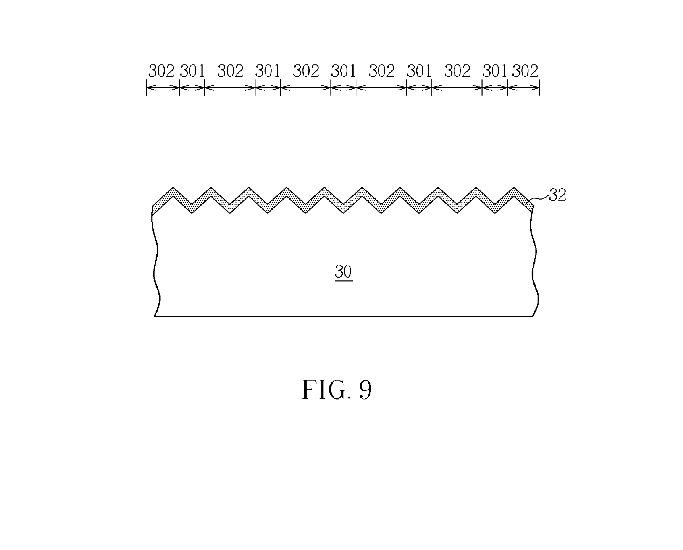

As illustrated in FIG. 9, then a dopant source layer 32 is formed on the first region 301 and the second region 302 of the substrate 30. The dopant source layer 32 includes one or multiple types of dopants. In accordance with the present embodiment, the dopants are n-type dopants, e.g. phosphorus atoms. In addition, the dopant source layer 32 may be formed using a spin coating process, a spray coating process or a deposition process, e.g. a plasma-enhanced chemical vapor deposition (PECVD) process, but is not limited thereto.

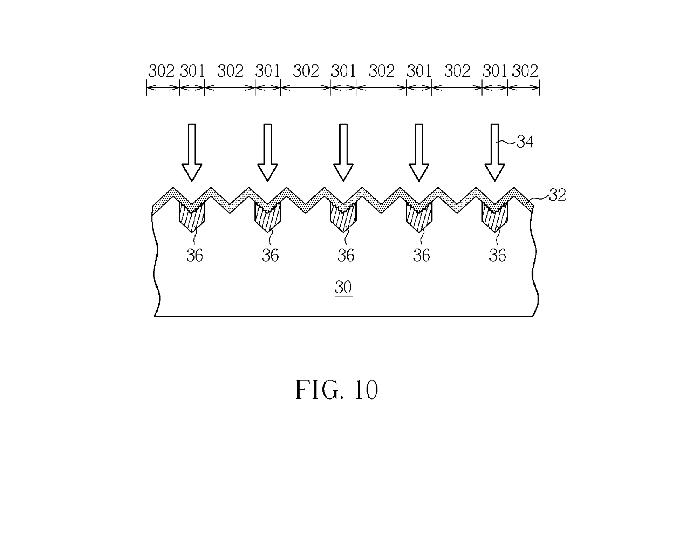

As illustrated in FIG. 10, then a laser doping process is performed using a laser beam 34 to locally irradiate the dopant source layer 32 corresponding to the first region 301 of the substrate 30 so that the dopants of the dopant source layer 32 on the first region 301 irradiated by the laser beam 34 absorb the energy of the laser beam 34 and diffuse downward into the substrate 30 to form a heavily doped region 36. In the present embodiment, the surface resistance of the heavily doped region 36 is substantially between 5 ohm/cm2 and 100 ohm/cm2, but is not limited thereto. In addition, the laser beam 34 irradiating the first region 301 melts the surface of the substrate 30 in the first region 301 so that the surface of the substrate 30 is recrystallized and a surface roughness of at the substrate 30 in the first region 301 is changed. Thus, the surface roughness of the substrate 30 in the first region 301 would be significantly different from the surface roughness of the substrate 30 in the second region 302, which therefore forms a visible patterned mark. In accordance with the present embodiment, the laser beam 34 includes a pulsed laser beam, and the wavelength of the laser beam 34 is substantially between 200 nanometers and 2000 nanometers, but the types and wavelength of the laser beam 34 are not limited thereto.

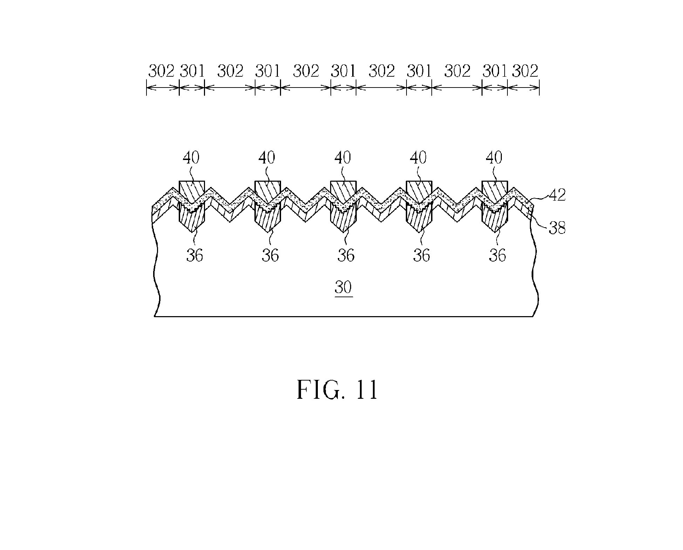

As illustrated in FIG. 11, the dopant source layer 32 is removed. Next, a lightly doped region 38 is formed in the first region 301 and the second region 302of the substrate 30. The lightly doped region 38 may be formed using a thermal diffusion process, and the surface resistance of the lightly doped region 38 is substantially between 60 ohm/cm2 and 200 ohm/cm2, but is not limited thereto. Then, an anti-reflective layer 42 may be formed on the surface of the substrate 30 to reduce the reflection of incident light which increases the light utilization efficiency. Next, the visible patterned mark is used as an alignment mark to form a patterned electrode 40 on the surface of the substrate 30 in the first region 301. With the alignment mark, the patterned electrode 40 is formed in the first region 301 precisely and in contact with the heavily doped region 36, reducing the contact resistance effectively.

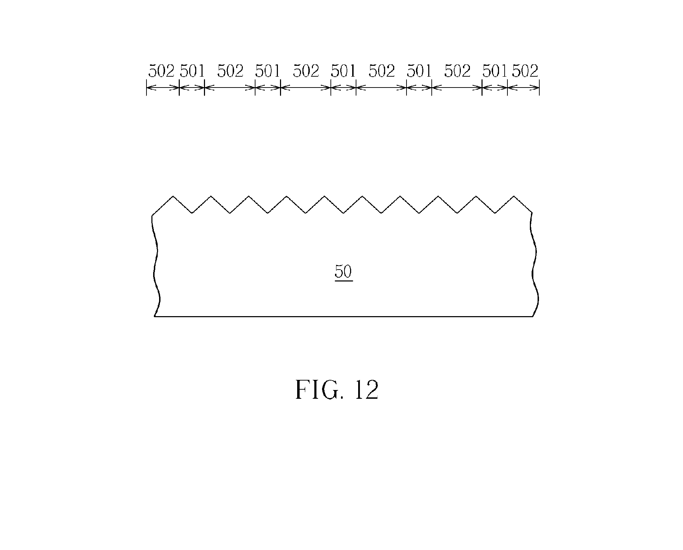

Referring to FIG. 12 to FIG. 15, FIG. 12 to FIG. 15 are schematic diagrams illustrating a method of forming a solar cell in accordance with a third preferred embodiment of the present invention. As illustrated in FIG. 12, first a substrate 50 is provided, and the substrate 50 includes a first region 501 and a second region 502. In accordance with the present embodiment, the substrate 50 is a silicon substrate, and the substrate 50 has a first doping type, e.g. a p-type doping. In addition, a texturing process may be optionally performed on the surface of the substrate 50 to form a rough surface.

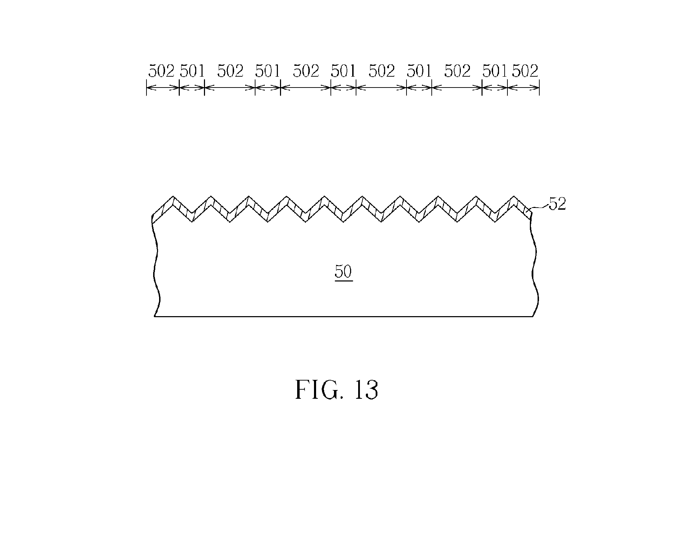

As illustrated in FIG. 13, then a lightly doped region 52 is formed in the first region 501 and the second region 502 of the substrate 50. The lightly doped region 52 may be formed, for example, using a thermal diffusion process, and the surface resistance of the lightly doped region 52 is substantially between 60 ohm/cm2 and 200 ohm/cm2, but is not limited thereto.

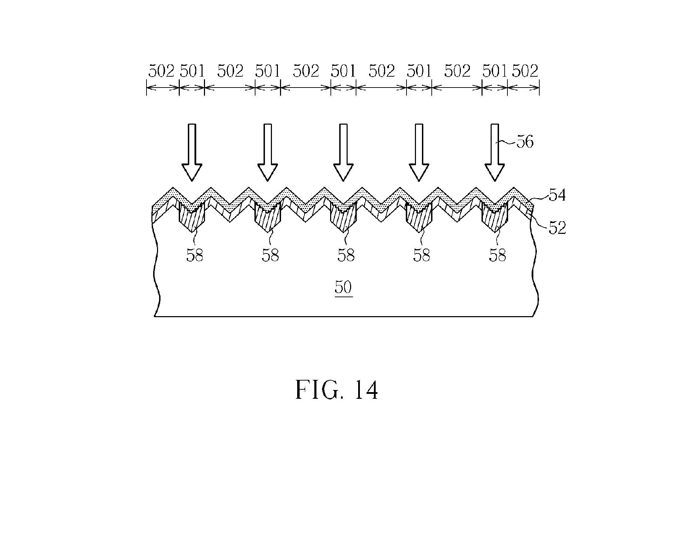

As illustrated in FIG. 14, then a dopant source layer 54 is formed on the first region 501 and the second region 502 of the substrate 50. The dopant source layer 54 includes one or multiple types of dopants. In accordance with the present embodiment, the dopants are n-type dopants, e.g. phosphorus atoms. In addition, the dopant source layer 54 may be formed using a spin coating process, a spray coating process or a deposition process, e.g. a plasma-enhanced chemical vapor deposition process, but is not limited thereto. Next, a laser doping process is performed using a laser beam 56 to locally irradiate the dopant source layer 54 corresponding to the first region 501 of the substrate 50, so that the dopants of the dopant source layer 54 on the first region 501 irradiated by the laser beam 56 absorb the energy of the laser beam 56 and diffuse downward into the substrate 50 to form a heavily doped region 58. The surface resistance of the heavily doped region 58 is substantially between 5 ohm/cm2 and 100 ohm/cm2, but is not limited thereto. In addition, the laser beam 56 irradiating the first region 501 would melt the surface of the substrate 50 in the first region 501 so that the surface of the substrate 50 is recrystallized and a surface roughness of the substrate 50 in the first region 501 is changed. Thus, the surface roughness of the substrate 50 in the first region 501 is significantly different from the surface roughness of the substrate 50 in the second region 502, forming a visible patterned mark. In accordance with the present embodiment, the laser beam 56 includes a pulsed laser beam, and the wavelength of the laser beam 56 is substantially between 200 nanometers and 2000 nanometers, but the types and wavelength of the laser beam 56 are not limited thereto.

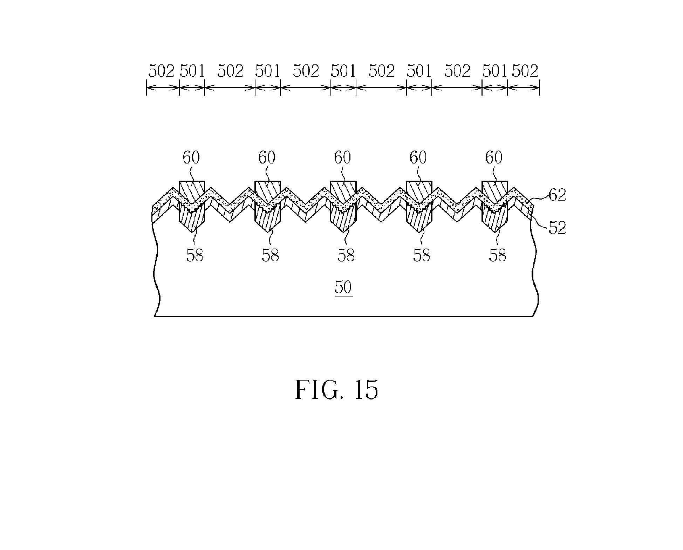

As illustrated in FIG. 15, the dopant source layer 54 is removed. Before forming the patterned electrode 60, an anti-reflective layer 62 may be formed on the surface of the substrate 50 to reduce the reflection of incident light which increases the light utilization efficiency. Next the visible patterned mark is used as an alignment mark to form a patterned electrode 60 on the surface of the substrate 50 in the first region 501. With the alignment mark, the patterned electrode 60 is formed on the first region 501 precisely and in contact with the heavily doped region 58, reducing the contact resistance effectively.

For completeness, various aspects of the invention are set out in the following numbered clauses:
Clause 1: A method of forming a solar cell, comprising: providing a substrate, wherein the substrate includes a first region and a second region; forming a dopant source layer on the first region and the second region of the substrate, wherein the dopant source layer comprises one or multiple types of dopants; performing a laser doping process using a laser beam to locally irradiate the dopant source layer corresponding to the first region of the substrate so that the dopants of the dopant source layer on the first region irradiated by the laser beam locally diffuse downward into the substrate, wherein the laser beam changes a surface property of the substrate in the first region to form a visible patterned mark; removing the dopant source layer; and using the visible patterned mark as an alignment mark to form a patterned electrode on the first region of the substrate.
Clause 2: The method of forming the solar cell of clause 1, wherein the substrate has a first doping type, and the dopants have a second doping type.
Clause 3: The method of forming the solar cell of clause 1, wherein during the laser doping process, the dopants disposed on the first region absorb energies of the laser beam and diffuse downward into the substrate.
Clause 4: The method of forming the solar cell of clause 1, wherein the laser doping process comprises using the laser beam to melt a surface of the substrate in the first region and to recrystallize the surface of the substrate to change a surface roughness of the surface of the substrate in the first region.
Clause 5: The method of forming the solar cell of clause 4, wherein the alignment mark used as the visible patterned mark is formed by a difference between the surface roughness of the substrate in the first region and a surface roughness of the substrate in the second region.
Clause 6: The method of forming the solar cell of clause 1, wherein the laser beam comprises a pulsed laser beam and a wavelength of the laser beam is substantially between 200 nanometers and 2000 nanometers.
Clause 7: The method of forming the solar cell of clause 1, wherein the patterned electrode is formed by a screen printing process.
Clause 8: The method of forming the solar cell of clause 1, wherein the patterned electrode is formed by an ink-jet printing process.
Clause 9: The method of forming the solar cell of clause 1, further comprising forming a lightly doped region in the first region and the second region of the substrate.
Clause 10: The method of forming the solar cell of clause 9, wherein a surface resistance of the lightly doped region is substantially between 60 ohm/cm2 and 200 ohm/cm2.
Clause 11: The method of forming the solar cell of clause 9, wherein the step of forming the dopant source layer on the first region and the second region of the substrate and forming the lightly doped region in the first region and the second region of the substrate comprise: performing a thermal diffusion process, and introducing at least a source gas containing the dopants during the thermal diffusion process to form the lightly doped region in the first region and the second region of the substrate and to form the dopant source layer on the first region and the second region of the substrate simultaneously.
Clause 12: The method of forming the solar cell of clause 11, wherein the source gas comprises a phosphorus-containing gas and the dopant source layer comprises a phosphosilicate glass layer.
Clause 13: The method of forming the solar cell of clause 9, wherein the laser beam locally irradiates the dopant source layer corresponding to the first region of the substrate so that the dopants of the dopant source layer on the first region irradiated by the laser beam locally diffuse downward into the substrate to form a heavily doped region.
Clause 14: The method of forming the solar cell of clause 13, wherein the step of forming the lightly doped region in the first region and the second region of the substrate is performed subsequent to the step of forming the heavily doped region by the laser doping process.
Clause 15: The method of forming the solar cell of clause 13, wherein the step of forming the lightly doped region in the first region and the second region of the substrate is performed prior to the step of forming the heavily doped region by the laser doping process.
Clause 16: The method of forming the solar cell of clause 13, wherein a surface resistance of the heavily doped region is substantially between 5 ohm/cm2 and 100 ohm/cm2.
Clause 17: The method of forming the solar cell of clause 1, wherein the dopant source layer is formed by a spin coating process.
Clause 18: The method of forming the solar cell of clause 1, wherein the dopant source layer is formed by a spray coating process.
Clause 19: The method of forming the solar cell of clause 1, wherein the dopant source layer is formed by a plasma-enhanced chemical vapor deposition process.

In summary, the method of forming the solar cell in accordance with the present invention utilizes the laser doping process to form the heavily doped region in the substrate, and the laser doping process also changes the surface property of the substrate in the heavily doped region simultaneously. Thus, the visible patterned mark is formed without introducing additional processes. With the presence of the visible patterned mark, in the follow-up manufacturing procedures of the patterned electrode, the visible patterned mark may be used as the alignment mark for precise alignment, so that the patterned electrode can be precisely formed on the surface of the substrate in the heavily doped region, and the patterned electrode is completely overlapping with the heavily doped region. Therefore, the contact resistance between the patterned electrode made by metallic materials and the heavily doped region may be reduced significantly, improving the power generation efficiency of the solar cell.

## Claims

1. A method of forming a solar cell, comprising:
providing a substrate (30, 50, 70) wherein the substrate (30, 50, 70) includes a first region (301, 501, 701) and a second region (302, 502, 702);
forming a dopant source layer (32, 54, 74) on the first region (301, 501, 701) and the second region (302, 502, 702) of the substrate (30, 50, 70), wherein the dopant source layer (32, 54, 74) comprises one or multiple types of dopants;
performing a laser doping process using a laser beam to locally irradiate the dopant source layer (32, 54, 74) corresponding to the first region (301, 501, 701) of the substrate (30, 50, 70) so that the dopants of the dopant source layer (32, 54, 74) on the first region (301, 501, 701) irradiated by the laser beam locally diffuse downward into the substrate (30, 50, 70), wherein the laser beam changes a surface property of the substrate (30, 50, 70) in the first region (301, 501, 701) to form a visible patterned mark;
removing the dopant source layer (32, 54, 74); and
using the visible patterned mark as an alignment mark to form a patterned electrode (40, 60, 80) on the first region (301, 501, 701) of the substrate (30, 50, 70).

2. The method of forming the solar cell of claim 1, wherein during the laser doping process, the dopants disposed on the first region (301, 501, 701) absorb energies of the laser beam and diffuse downward into the substrate (30, 50, 70).

3. The method of forming the solar cell of claim 1, **characterized in that** the laser doping process comprises using the laser beam to melt a surface of the substrate (30, 50, 70) in the first region (301, 501, 701) and to recrystallize the surface of the substrate (30, 50, 70) to change a surface roughness of the surface of the substrate (30, 50, 70) in the first region (301, 501, 701).

4. The method of forming the solar cell of claim 3, **characterized in that** the alignment mark used as the visible patterned mark is formed by a difference between the surface roughness of the substrate (30, 50, 70) in the first region (301, 501, 701) and a surface roughness of the substrate (30, 50, 70) in the second region (302, 502, 702).

5. The method of forming the solar cell of claim 1, **characterized in that** the laser beam comprises a pulsed laser beam, and a wavelength of the laser beam is substantially between 200 nanometers and 2000 nanometers.

6. The method of forming the solar cell of claim 1, wherein the patterned electrode (40, 60, 80) is formed by a screen printing process or by an ink-jet printing process.

7. The method of forming the solar cell of claim 1, **characterized by** further forming a lightly doped region (38, 52, 72) in the first region (301, 501, 701) and the second region (302, 502, 702) of the substrate (30, 50, 70).

8. The method of forming the solar cell of claim 7, **characterized in that** a surface resistance of the lightly doped region (38, 52, 72) is substantially between 60 ohm/cm² and 200 ohm/cm².

9. The method of forming the solar cell of claim 7, wherein the step of forming the dopant source layer (32, 54, 74) on the first region (301, 501, 701) and the second region (302, 502, 702) of the substrate (30, 50, 70) and forming the lightly doped region (38, 52, 72) in the first region (301, 501, 701) and the second region (302, 502, 702) of the substrate (30, 50, 70) is further **characterized by**:
performing a thermal diffusion process, and introducing at least a source gas containing the dopants during the thermal diffusion process to form the lightly doped region (38, 52, 72) in the first region (301, 501, 701) and the second region (302, 502, 702) of the substrate (30, 50, 70) and to form the dopant source layer (32, 54, 74) on the first region (301, 501, 701) and the second region (302, 502, 702) of the substrate (30, 50, 70) simultaneously.

10. The method of forming the solar cell of claim 9, **characterized in that** the source gas comprises a phosphorus-containing gas, and the dopant source layer (32, 54, 74) comprises a phosphosilicate glass layer.

11. The method of forming the solar cell of claim 7, **characterized in that** the laser beam locally irradiates the dopant source layer (32, 54, 74) corresponding to the first region (301, 501, 701) of the substrate (30, 50, 70) so that the dopants of the dopant source layer (32, 54, 74) on the first region (301, 501, 701) irradiated by the laser beam locally diffuse downward into the substrate (30, 50, 70) to form a heavily doped region (36, 58, 78).

12. The method of forming the solar cell of claim 11, wherein the step of forming the lightly doped region (38, 52, 72) in the first region (301, 501, 701) and the second region (302, 502, 702) of the substrate (30, 50, 70) is performed subsequent to the step of forming the heavily doped region (36, 58, 78) by the laser doping process.

13. The method of forming the solar cell of claim 11, wherein the step of forming the lightly doped region (38, 52, 72) in the first region (301, 501, 701) and the second region (302, 502, 702) of the substrate (30, 50, 70) is performed prior to the step of forming the heavily doped region (36, 58, 78) by the laser doping process.

14. The method of forming the solar cell of claim 11, **characterized in that** a surface resistance of the heavily doped region (36, 58, 78) is substantially between 5 ohm/cm² and 100 ohm/cm².

15. The method of forming the solar cell of claim 1, wherein the dopant source layer (32, 54, 74) is formed by a spin coating process, by a spray coating process, or by a plasma-enhanced chemical vapor deposition process.
